# FASCICULE DE BREVET EUROPEEN

(11) **EP 4 481 961 B1**
(45) Date de publication et mention de la délivrance du brevet: **11.02.2026**
(21) Numéro de dépôt: 24183765.7
(22) Date de dépôt: 21.06.2024
(51) Int. Cl.: H01S 5/0234, G02F 1/00, H01L 21/00, H01S 5/024, H01S 5/042, H01S 5/22, H01S 5/20

(54) **COMPOSANT OPTOÉLECTRONIQUE À CRÊTE ENTERRÉE À HAUTE PUISSANCE**
OPTOELEKTRONISCHES BAUELEMENT MIT VERGRABENER SPITZE MIT HOHER LEISTUNG
OPTOELECTRONIC COMPONENT WITH A HIGH-POWER BURIED RIDGE

(30) Priorité: 22.06.2023 FR 2306460
(43) Date de publication de la demande: 25.12.2024
(73) Titulaire: THALES, 92190 Meudon (FR)
(72) Inventeur: POMMEREAU, Frédéric, 91767 Palaiseau (FR); NEEL, Delphine, 91767 Palaiseau (FR)
(74) Mandataire: Atout PI Laplace

(56) Documents cités:
- EP-A1- 2 866 313
- EP-A1- 2 866 316
- KR-A- 20040 079 636
- US-A- 6 118 801
- US-A1- 2004 005 728
- US-A1- 2016 111 855

## Description

L'invention concerne le domaine des dispositifs optoélectroniques actifs à ruban enterré comprenant une zone active en semi-conducteur III-V. Ce type de composant, qui peut être un laser, un amplificateur, un modulateur ou un détecteur, est par exemple utilisé dans le domaine des télécommunications.

Les composants optoélectroniques à crête (ou "ridge optoelectronic device" en anglais) sont des composants optiques utilisés dans les dispositifs optoélectroniques tels que les lasers à semi-conducteurs et les amplificateurs optiques. Ces structures se caractérisent par une région active étroite et allongée (typiquement de quelques micromètres de largeur et de plusieurs centaines de micromètres de longueur) entourée de couches de matériaux à plus faible indice de réfraction. Le terme "ridge" fait référence à la forme de la région active, qui est souvent en forme de crête ou ruban. Cette forme permet de confiner la lumière dans une zone restreinte, ce qui est essentiel pour obtenir une émission laser à partir d'un semi-conducteur. Les composants optoélectroniques à crête sont généralement fabriqués en utilisant des techniques de lithographie et de gravure pour sculpter les couches de semi-conducteurs en forme de crête ou ruban. Des électrodes sont ensuite déposées sur la région active pour permettre l'injection de courant électrique et l'excitation de la lumière dans la région active. Les composants optoélectroniques à crête sont largement utilisés dans les dispositifs optiques à semi-conducteurs en raison de leur capacité à produire des faisceaux lumineux étroits et de haute qualité, avec une efficacité élevée et une faible consommation d'énergie.

Un développement plus avancé des composants optoélectroniques à crête est la structure à crête enterrée (traduction de « buried ridge » en anglais). La structure à crête enterrée consiste en une région active étroite et allongée (comme dans le cas de la structure à crête classique) qui est enterrée sous une couche de matériau à plus faible indice de réfraction appelée « couche d'enrobage ». L'avantage de la structure à crête enterrée est qu'elle permet de mieux contrôler la distribution spatiale de la lumière et d'obtenir une émission laser plus stable que dans une structure à crête classique. De plus, cette structure peut également réduire les pertes de lumière et améliorer l'efficacité de conversion d'énergie. La fabrication de la structure à crête enterrée implique généralement des techniques de lithographie, de gravure et de dépôt de couches épitaxiales pour créer la région active en forme de crête et la couche enterrée qui l'entoure.

Les dispositifs optoélectroniques, d'une manière générale, produisent beaucoup de chaleur lorsqu'ils sont soumis à un courant électrique lors de leur fonctionnement. Cette chaleur doit être dissipée efficacement pour éviter une surchauffe qui peut dégrader les performances du dispositif voir endommager le dispositif.

En ce sens, plusieurs problèmes ont été clairement identifiés avec les structures à crête enterrée connues dans l'état de l'art. En effet, les couches d'enrobages actuelles ne présentent pas de résultats satisfaisants en termes de dissipation thermique pour des dispositifs optoélectroniques à haute puissance.

La demande de brevet US 2004/005728 A1 décrit par exemple un composant optoélectronique comprenant en particulier une couche d'enrobage en nitrure d'aluminium, dans laquelle un ruban de guidage est enterré.

Nous allons commencer par introduire les solutions connues par l'Homme de l'art présentant des matériaux utilisés pour réaliser la couche d'enrobage dans les composants optoélectroniques à crête enterrée.

Une première solution connue concerne la réalisation de la couche d'enrobage en benzo-cyclobutène (BCB) qui présente une isolation électrique élevée et un indice de réfraction relatif permettant d'améliorer le guidage de l'onde électromagnétique confinée dans la zone active. Cependant, la couche d'enrobage en benzo-cyclobutène (BCB) présente une faible conductivité thermique, ce qui dégrade la dissipation thermique de la chaleur produite par le composant optoélectronique.

Une deuxième solution connue concerne la réalisation de la couche d'enrobage en un semiconducteur dopé par un métal, tel que l'InP dopé fer. Cette solution offre une bonne conductivité thermique permettant de dissiper la chaleur produite. Cependant, la solution proposée présente une isolation électrique non suffisante. Cela induit une dégradation des performances du composant optoélectronique avec une augmentation des courants de pertes et la création de capacités parasites.

Pour pallier les limitations des solutions existantes, l'invention propose un composant optoélectronique, une hétérostructure à crête enterrée dans une couche d'enrobage en nitrure, plus particulièrement en nitrure d'aluminium ou en nitrure de bore. Le composant optoélectronique selon l'invention présente des avantages considérables en termes d'amélioration, de dissipation thermique et d'isolation électrique par rapport aux solutions de l'état de l'art.

De plus, le composant optoélectronique selon l'invention est compatible avec l'assemblage de type « flip-chip » (ou « puce retournée » en français) avec au moins un circuit externe.

L'invention concerne en outre un procédé de fabrication permettant ainsi de fabriquer une hétérostructure à crête enterrée dans une couche d'enrobage en nitrure, sans faire recours à une opération de gravure localisée de ladite couche d'enrobage. Cela permet d'éviter le recours à des solutions de gravure agressive pouvant endommager l'hétérostructure à crête. Le procédé selon l'invention permet ainsi de surmonter les problèmes de fabrication liés à la difficulté de gravure d'une couche d'enrobage en nitrure.

L'invention est définie par les revendications indépendantes.

L'invention a pour objet un composant optoélectronique selon la revendication 1 comprenant notamment un empilement de couches sur un substrat selon une direction d'empilement ; ledit empilement comprenant :
- une hétérostructure à crête comprenant une base et un ruban de guidage s'étendant selon une direction de guidage orthogonale à la direction d'empilement, le ruban de guidage étant configuré pour propager une onde lumineuse confinée ;
- une couche d'enrobage en nitrure, dans laquelle ledit ruban de guidage est enterré.

Selon un aspect particulier de l'invention, la couche d'enrobage est en nitrure d'aluminium ou en nitrure de bore.

Selon un aspect particulier de l'invention, le composant optoélectronique présente une épaisseur supérieure à la hauteur du ruban de guidage.

Selon un aspect particulier de l'invention, la couche d'enrobage présente une surface supérieure plane.

Selon l'invention, l'hétérostructure à crête comprend :
- une structure de confinement inférieure réalisée en un premier matériau semiconducteur ;
- une zone active réalisée en au moins un deuxième matériau semiconducteur ;
- une structure de confinement supérieure réalisée en un troisième matériau semiconducteur ;
La zone active étant confinée entre la structure de confinement supérieure et la structure de confinement inférieure ; ladite zone active étant conçue pour générer des photons par recombinaison de porteurs de charges injectés dans les structures de confinement supérieure et inférieure Le ruban de guidage étant formé par au moins une partie de la structure de confinement supérieure.

Selon l'invention, le composant optoélectronique comprend une première électrode en un matériau conducteur ayant au moins une première partie déposée sur la surface supérieure du ruban de guidage.

Selon l'invention, le composant optoélectronique comprend une seconde électrode en un matériau conducteur connectée à la structure de confinement inférieure à travers un via traversant la couche d'enrobage.

Selon l'invention, chacune des électrodes présente au moins une seconde partie déposée sur la surface supérieure de la couche d'enrobage.

Selon un aspect particulier de l'invention, la structure de confinement supérieure est dopée N et la structure de confinement inférieure est dopée P ou inversement.

Selon un aspect particulier de l'invention, l'hétérostructure à crête comprend une couche d'arrêt de gravure pour réaliser une gravure sélective dudit troisième matériau semiconducteur formant le ruban de guidage. Ladite couche d'arrêt de gravure étant confinée entre la base et le ruban de guidage.

Selon un aspect particulier de l'invention, la couche d'arrêt de gravure présente une épaisseur inférieure 20 nm.

Selon un aspect particulier de l'invention, le composant optoélectronique comprend en outre une couche de contact ohmique déposée sur la surface supérieure du ruban de guidage. La couche de contact ohmique étant réalisée par un quatrième matériau semiconducteur ayant un gap d'énergie inférieur à celui du troisième matériau semiconducteur.

L'invention a également pour objet un procédé de fabrication d'un dispositif optoélectronique, selon la revendication 1, comprenant les étapes suivantes :
i) fabriquer un empilement de couches semiconductrices déposées sur un substrat selon une direction d'empilement ; ledit empilement étant dénommé « empilement initial » ;
ii) fabriquer un premier ruban intermédiaire et un second ruban intermédiaire en gravant partiellement l'empilement initial ; chaque ruban intermédiaire étant couvert par une couche sacrificielle ; chaque ruban intermédiaire étant disposé sur une base formée par les couches non-gravées dudit empilement initial ; chaque ruban intermédiaire s'étendant selon une direction de guidage orthogonale à la direction d'empilement ;
iii) déposer une couche d'enrobage en nitrure de manière à encapsuler le premier ruban intermédiaire et le second ruban intermédiaire ;
iv) planariser la couche d'enrobage pour obtenir une surface supérieure plane de la couche d'enrobage et de manière à découvrir la couche sacrificielle du premier ruban intermédiaire et du second ruban intermédiaire ;
v) enlever intégralement la couche sacrificielle par gravure pour obtenir au moins un ruban de guidage enterré dans la couche d'enrobage en nitrure à partir du premier ruban intermédiaire .

Selon un aspect particulier de l'invention, le procédé de l'empilement initial comprend dans l'ordre en partant dudit substrat :
- une première couche dopée N ou P en un premier matériau semiconducteur destinée à former une structure de confinement inférieure ;
- au moins une deuxième couche en un deuxième matériau semiconducteur ayant un gap d'énergie inférieur à celui du premier matériau semiconducteur destinée à former une zone active ;
- au moins une troisième couche ayant un dopage opposé à celui de la première couche , réalisée par un troisième matériau semiconducteur ayant un gap d'énergie supérieur à celui du deuxième matériau semiconducteur et destinée à faire partie d'une structure de confinement supérieure ;
- une couche de contact ohmique en un quatrième matériau semiconducteur ayant un gap d'énergie inférieur à celui du troisième matériau semiconducteur ;
- une couche sacrificielle en un cinquième matériau permettant de réaliser une gravure sélective par rapport à la couche de contact ohmique ;

Selon un aspect particulier de l'invention, l'étape ii) est réalisée en gravant partiellement la couche sacrificielle , la couche de contact ohmique et l'au moins une troisième couche ;

Selon un aspect particulier de l'invention, le procédé comprend en outre les étapes suivantes :
vi) fabriquer au moins un via traversant jusqu'à la première couche en gravant intégralement ou partiellement le second ruban intermédiaire et partiellement au moins la deuxième couche ;
vii) déposer une première électrode en un matériau conducteur ayant au moins une première partie déposée sur la surface supérieure du ruban de guidage et une seconde électrode en un matériau conducteur ayant au moins une première partie déposée sur la deuxième couche à travers l'au moins via .

Selon un aspect particulier de l'invention, l'étape de planarisation iv) est réalisée par polissage via une surface abrasive comprenant des billes ayant un diamètre inférieur à 5µm.

D'autres caractéristiques et avantages de la présente invention apparaîtront mieux à la lecture de la description qui suit en relation aux dessins annexés suivants.
[Fig. 1] la figure 1 illustre une vue partielle d'un composant optoélectronique à crête selon l'état de l'art.
[Fig. 2] la figure 2 représente une vue en coupe d'un composant optoélectronique à crête enterrée selon l'invention.
[Fig. 3a] la figure 3a illustre la première étape du procédé de fabrication du composant optoélectronique selon l'invention.
[Fig. 3b] la figure 3b illustre la deuxième étape du procédé de fabrication du composant optoélectronique selon l'invention.
[Fig. 3c] la figure 3c illustre la troisième étape du procédé de fabrication du composant optoélectronique selon l'invention.
[Fig. 3d] la figure 3d illustre la quatrième étape du procédé de fabrication du composant optoélectronique selon l'invention.
[Fig. 3e] la figure 3e illustre la cinquième étape du procédé de fabrication du composant optoélectronique selon l'invention.
[Fig. 3f] la figure 3f illustre la sixième étape du procédé de fabrication du composant optoélectronique selon l'invention.
[Fig. 3g] la figure 3g illustre la septième étape du procédé de fabrication du composant optoélectronique selon l'invention.
[Fig. 4] la figure 4 illustre un organigramme du procédé de fabrication du composant optoélectronique selon l'invention.

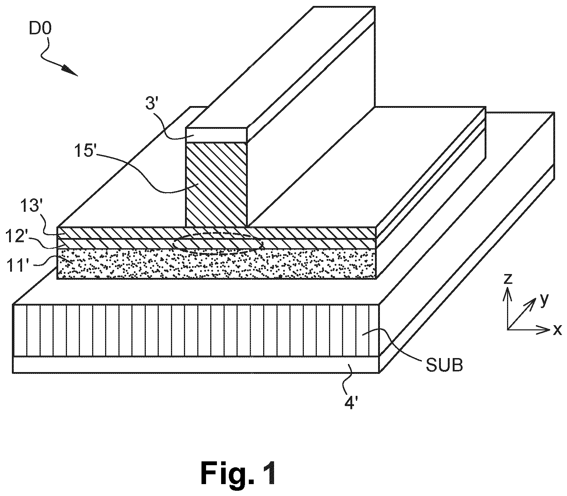

La figure 1 illustre une vue tridimensionnelle d'un exemple d'un composant optoélectronique à crête D0 selon l'état de l'art afin de faciliter la compréhension de la structure de base d'un composant optoélectronique à crête.

Le composant optoélectronique à crête D0 est réalisé sur un substrat SUB. Le substrat peut être un substrat massif en un matériau semiconducteur de type III-V ou un empilement de plusieurs matériaux semiconducteurs assemblés. Le composant optoélectronique à crête D0 comprend une hétérostructure à crête réalisée en un premier matériau semiconducteur et comprenant une couche active 12' confinée entre une structure de confinement supérieure 13',15' et une structure de confinement inférieure 11'. Le composant optoélectronique à crête D0 comprend en outre une première électrode 3' et une seconde électrode 4' réalisée par des couches électriquement conductrices.

La structure de confinement inférieure 11' est réalisée par une couche 11' en un matériau semiconducteur. La structure de confinement inférieure 11' est dopée P ou N. La structure de confinement supérieure 13',15' est réalisée par une couche 13' sur laquelle repose un ruban 15' réalisés en un matériau semiconducteur. Le ruban 15' s'étend selon la direction Y orthogonale à la direction d'empilement Z. La structure de confinement supérieure 13',15' est dopée de manière opposée à la structure de confinement inférieure 11'. La couche active 12' est réalisée en un matériau intrinsèque ayant un gap d'énergie inférieur aux gaps d'énergies des matériaux constituant la structure de confinement inférieure 11' et la structure de confinement supérieure 13',15'. La première électrode 3' est déposée directement sur la surface supérieure du ruban 15' de manière à être connectée électriquement à la structure de confinement supérieure 13',15'. La seconde électrode 4' est déposée sur la face inférieure du substrat SUB de manière à être connectée électriquement à la structure de confinement inférieure 11'.

La première électrode 3' et la seconde électrode 4' sont destinées à être connectées à un générateur électrique externe non représenté. L'application d'une tension électrique entre les deux électrodes 3' et 4' injecte des porteurs de charges positives (trous) dans le volume de la structure de confinement supérieure 13',15' (dopée P) et des porteurs de charges négatives (électrons) dans le volume de la structure de confinement inférieure 11' (dopée N). Les porteurs de charges de signes opposés se retrouvent confinés dans la couche active 12' intrinsèque à petit gap, pour se recombiner. La recombinaison des électrons et des trous dans la couche active 12' induit l'émission de photons à une longueur d'onde correspondant au gap d'énergie du matériau constituant ladite couche active 12'. Les photons émis par recombinaison de porteurs de charges injectés sont confinés dans lesdites couches et forment une onde électromagnétique qui se propage selon la direction de guidage Y du ruban 15'.

Comme indiqué précédemment, lorsque le dispositif optoélectronique à crête D0 fonctionne à haute fréquence et/ou à haute puissance, la chaleur produite par le dispositif pose un problème affectant la performance et la fiabilité du dispositif.

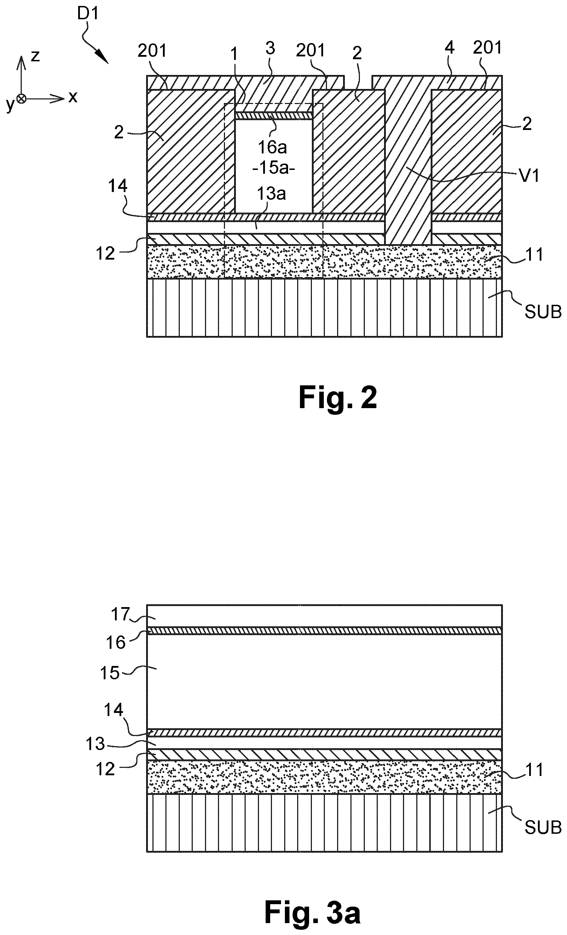

La figure 2 représente une vue en coupe d'un composant optoélectronique D1 selon l'invention, permettant de résoudre les problèmes préalablement décrits.

Le composant optoélectronique D1 comprend un empilement de couches sur un substrat SUB selon une direction d'empilement Z. Le substrat SUB est réalisé par une tranche massive en un matériau semiconducteur de type III-V seule.

Alternativement, le substrat SUB est réalisé par une tranche massive en un matériau semiconducteur de type III-V assemblée à un autre substrat en silicium, ou en SOI ou en SiO2 déposée sur silicium. Alternativement, le substrat SUB est réalisé par une couche en un matériau semiconducteur de type III-V déposée sur un autre substrat en silicium, ou en SOI ou en SiO2 déposée sur silicium. À titre d'exemple non limitatif, le matériau semiconducteur de type III-V est le phosphure d'indium InP ou l'arséniure de gallium GaAs.

Ledit empilement de couches comprend une hétérostructure à crête 1 pour générer et/ou guider une onde électromagnétique, une couche d'enrobage 2 , une première électrode 3 et une seconde électrode 4.

L'hétérostructure à crête 1 comprenant une zone active 12 confinée entre une structure de confinement supérieure 13a,14,15a et une structure de confinement inférieure 11. La structure de confinement inférieure 11 comprend au moins une première couche 11 en un premier matériau semiconducteur. Avantageusement, le premier matériau semiconducteur est de type III-V, à titre d'exemple en InP ou en GaAs. Le premier matériau semiconducteur présente une première valeur de gap d'énergie Eg₁.

La zone active 12 est réalisée en un deuxième matériau semiconducteur ayant une deuxième valeur de gap d'énergie Eg₂. Avantageusement, la zone active 12 est réalisée en un alliage ternaire ou quaternaire de type III-V par exemple InGaAsP ou InGaAlAs. Alternativement, la zone active 12 est réalisée par un empilement de couches alternées de différentes compositions d'alliages ternaires ou quaternaires de type III-V. L'épaisseur de chaque couche du dit empilement étant de quelques nm à une dizaine de nm de manière à former une série de puits quantiques (traduction de l'expression anglaise « multi-quantum well layers »).

La structure de confinement supérieure 13a,14,15a comprend une base planaire 13a,14 selon un plan orthogonal à la direction d'empilement Z ; et un ruban de guidage 15a disposé sur ladite base. Le ruban de guidage 15a s'étend longitudinalement selon une direction de guidage Y orthogonale à la direction d'empilement Z. La base planaire comprend une couche 13a réalisée par un troisième matériau semiconducteur ayant une troisième valeur de gap d'énergie Eg₃. Le ruban de guidage 15a est réalisé par ledit troisième matériau semiconducteur. Avantageusement, le troisième matériau semiconducteur est identique au premier matériau semiconducteur. Cela permet de faciliter la croissance par épitaxie de l'hétérostructure à crête.

La structure de confinement inférieure 11 est dopée P ou N. La structure de confinement supérieure 13a,14,15a est dopée de manière opposée à la structure de confinement inférieure 11. Dans la suite du descriptif on considère que la structure de confinement inférieure 11 est dopée N et que la structure de confinement supérieure 13a,14,15a est dopée P, à titre illustratif non limitatif.

Dans le cas d'une zone active réalisée par une couche massive, la deuxième valeur de gap d'énergie Eg₂ du matériau constituant la zone active 12 est inférieure à la première valeur de gap d'énergie Eg₁ de la structure de confinement inférieure 11. La deuxième valeur de gap d'énergie Eg₂ du matériau constituant la zone active 12 est inférieure à la troisième valeur de gap d'énergie Eg₃ de la structure de confinement supérieure 13a,14,15a. La zone active 12 est intrinsèque, dans le sens non dopée.

Dans le cas d'une zone active réalisée par empilement de couches alternées, les matériaux constituant les couches de l'empilement alterné présentent chacune une valeur de gap d'énergie inférieure à la première valeur de gap d'énergie Eg₁ de la structure de confinement inférieure 11.

La première électrode 3 est une microstructure en un matériau conducteur ayant au moins une première partie déposée sur la surface supérieure du ruban de guidage 15a pour créer un chemin électrique entre l'électrode et la structure de confinement supérieure 13a,14,15a. La seconde électrode 4 est une microstructure en un matériau conducteur ayant au moins une première partie déposée sur la structure de confinement inférieure 11 à travers un via V1 traversant la couche d'enrobage 2. Les parois internes du via V1 sont passivées par une couche de passivation 41 en diélectrique. La couche de passivation 41 déposée sur les parois internes du via V1 peut être réalisée en silice ou en nitrure de silicium. Avantageusement, la couche de passivation 41 déposée sur les parois internes du via V1 présente une épaisseur de 100nm. Ladite couche de passivation 41 permet d'isoler la seconde électrode 4 d'au moins la zone active 12.

La première électrode 3 et la seconde électrode 4 sont destinées à être connectées à un générateur électrique externe non représenté. L'application d'une tension électrique entre les deux électrodes 3 et 4 permet d'injecter des porteurs de charges positives (trous) dans le volume de la structure de confinement supérieure et des porteurs de charges négatives (électrons) dans le volume de la structure de confinement inférieure. Les porteurs de charges de signe opposés se retrouvent confinés dans la zone active 12 intrinsèque à petit gap, pour se recombiner. La recombinaison des électrons et des trous dans la zone active 12 permet l'émission de photons à une longueur d'onde correspondant à la deuxième valeur de gap d'énergie Eg₂. Les photons émis par recombinaison de porteurs de charges injectés sont confinés dans lesdites couches et forment une onde électromagnétique qui se propage selon la direction de guidage Y du ruban 15a.

L'hétérostructure à crête 1 est enterrée dans la couche d'enrobage 2. La couche d'enrobage 2 est réalisée par un nitrure présentant une bonne conductivité thermique et une bonne isolation électrique. Avantageusement, la couche d'enrobage 2 est réalisée en nitrure d'aluminium ou en nitrure de bore. Les caractéristiques thermiques de la couche d'enrobage 2 en nitrure permettent d'améliorer la dissipation thermique de la chaleur produite par l'hétérostructure à crête 1. Cela permet d'atteindre un fonctionnement à haute fréquence et à haute puissance. De plus, le choix de nitrures pour réaliser la couche d'enrobage 2 permet d'assurer une bonne isolation électrique de l'hétérostructure à crête 1, ce qui implique une amélioration de la performance d'émission et de guidage du composant optoélectronique D1. Avantageusement, la couche d'enrobage 2 présente une épaisseur supérieure à la hauteur du ruban de guidage 15a. Ainsi, les parois latérales du ruban de guidage 15a s'étendant selon la direction de guidage Y sont en contact avec la couche d'enrobage 2. Cela permet d'augmenter l'interface d'échange thermique entre la couche d'enrobage 2 et l'hétérostructure à crête 1 et ainsi améliorer la dissipation thermique dans le composant selon l'invention.

Avantageusement, la couche d'enrobage 2 présente une surface supérieure 201 plane. La surface supérieure 201 plane est parallèle au plan (X,Y) orthogonal à la direction d'empilement Z. La planéité de la surface supérieure 201 de la couche d'enrobage 2 permet d'avoir un support mécanique plan pour le dépôt des électrodes 3,4. Chacune des électrodes 3, 4 présente au moins une partie déposée sur la surface supérieure plane 201 de la couche d'enrobage 2. Un support mécanique plan permet l'assemblage du composant optoélectronique D1 avec au moins un circuit externe par la technique « flip-chip » (ou « puce retournée » en français). On rappelle que la technique d'assemblage « flip-chip » nécessite une mise en face à face d'une surface externe planaire du composant D1 comprenant des électrodes de contact avec une surface externe d'un autre circuit ayant aussi des électrodes de contact.

Avantageusement, la base de la structure de confinement supérieure comprend une couche d'arrêt de gravure 14 pour réaliser une gravure sélective du troisième matériau semiconducteur formant le ruban de guidage 15a. La couche d'arrêt de gravure 14 est confinée entre la base formée par la couche 13a et le ruban de guidage 15a. À titre d'exemple, lorsque le ruban de guidage 15a est formé par le phosphure d'indium InP, la couche d'arrêt de gravure 14 est réalisée par l'alliage GalnAsP pour permettre une gravure sélective de l'InP afin de fabriquer l'hétérostructure à crête 1. À titre d'exemple, lorsque le ruban de guidage 15a est formé par l'arséniure de gallium GaAs, la couche d'arrêt de gravure 14 est réalisée par l'alliage GalnP pour permettre une gravure sélective du GaAs afin de fabriquer l'hétérostructure à crête 1. L'épaisseur de la couche d'arrêt de gravure doit être inférieure à 20nm, de préférence égale à 10nm, pour ne pas engendrer une perturbation optique de l'onde électromagnétique guidée par le ruban de guidage 15a.

Le composant optoélectronique D1 comprend en outre une couche de contact ohmique 16a confinée entre la surface supérieure du ruban de guidage 15a et la première électrode 3. La couche de contact ohmique 16a est réalisée par un quatrième matériau semiconducteur ayant un gap d'énergie Eg₄ inférieur à celui du troisième matériau semiconducteur Eg₃. Cela permet d'obtenir un contact ohmique avec la première électrode 3 et non un contact de Schottky.

Optionnellement, les parois externes du ruban de guidage 15a sont recouvertes d'une couche d'adhérence, non représentée, permettant d'améliorer l'adhérence mécanique de la couche d'enrobage 2 avec la structure de confinement supérieur. La couche d'adhérence est une couche en diélectrique, par exemple en SiO₂, ayant une épaisseur inférieure à 0.5µm.

D'une manière générale, le dispositif D1 selon l'invention présente une structure à crête 1 enterrée dans une couche d'enrobage 2 en nitrure, de préférence en nitrure d'aluminium AIN, ou en nitrure de Bore BN. Ces matériaux présentent de nombreux avantages en tant que couche d'enrobage. Tout d'abord, ils sont résistants à la corrosion, ce qui en fait un choix idéal pour les applications dans des environnements agressifs. De plus, ils sont stables thermiquement, ce qui permet de conserver la robustesse mécanique de la couche même à des températures élevées. De plus, les matériaux listés sont également des matériaux électriquement isolants, mais aussi présentant une excellente conductivité thermique, ce qui en fait un choix idéal pour les applications de dissipation thermique où une bonne gestion de la chaleur est essentielle pour maintenir les performances et la fiabilité du composant optoélectronique.

Cependant, la fabrication d'une couche d'enrobage en nitrure, et plus particulièrement en AIN, ou BN, présente plusieurs contraintes techniques en raison des propriétés mécano-chimiques desdits matériaux. En effet, il s'agit de matériaux très durs et résistants à la corrosion, ce qui les rend difficiles à graver avec des méthodes conventionnelles de gravure d'un procédé de fabrication microtechnique. De plus, ces matériaux ont des énergies de liaison x-N très élevées ce qui rend leur gravure par voie humide ou plasma très difficile. En outre, l'utilisation de solutions de gravure très concentrées risque d'endommager les autres structures et plus particulièrement l'hétérostructure à crête. Pour ces raisons, l'invention propose en outre un procédé de fabrication du composant optoélectronique selon l'invention permettant de résoudre les problématiques précitées. Plus particulièrement, le procédé selon l'invention ne nécessite pas une opération de gravure de la couche d'enrobage 2 en nitrures ultrarésistants au niveau de la zone occupée par l'hétérostructure à crête 1. Les figures 3a à 3g illustrent les étapes du procédé de fabrication d'un composant optoélectronique selon l'invention.

La figure 3a illustre la première étape i) du procédé de fabrication du composant optoélectronique D1 selon l'invention. La première étape i) consiste à fabriquer sur le substrat SUB décrit précédemment un empilement de couches selon la direction d'empilement Z comprenant en partant dudit substrat:
- une première couche 11 dopée N ou P réalisé par le premier matériau semiconducteur ;
- une deuxième couche 12 réalisé par le deuxième matériau semiconducteur ayant un gap d'énergie inférieur à celui de la première couche 11. La deuxième couche 12 est destinée à former la zone active 12. Alternativement, la deuxième couche 12 est remplacée par un empilement de couches alternées de différentes compositions d'alliages ternaires ou quaternaires de type III-V. Les matériaux constituant les couches d'empilement alterné présentent chacune une valeur de gap d'énergie inférieure à celui de la première couche 11. L'empilement alterné est destiné à former la zone active 12. Dans la suite, nous allons décrire le mode de réalisation avec une zone active réalisée par la deuxième couche 12. Les étapes du procédé sont compatibles avec une zone active 12 réalisée en une couche massive 12 ou un empilement de couches alternées ;
- au moins une troisième couche 13, ayant un dopage opposé à celui de la première couche 11 et réalisée par le troisième matériau semiconducteur. La troisième couche 13 destinée à faire partie de la base de la structure de confinement supérieure ;
- une couche d'arrêt de gravure 14 conçue pour réaliser une gravure sélective du troisième matériau semiconducteur ;
- une quatrième couche 15, ayant un dopage opposé à celui de la première couche 11 et réalisée par le troisième matériau semiconducteur. La troisième couche 13 destinée à faire partie du ruban de guidage de la structure de confinement supérieure ;
- une couche de contact ohmique 16 en un quatrième matériau semiconducteur ayant un gap d'énergie inférieur à celui du troisième matériau semiconducteur ;
- une couche sacrificielle 17 en un cinquième matériau permettant de réaliser une gravure sélective par rapport à la couche de contact ohmique 16 ;

Selon un premier exemple, la première couche 11 est en InP dopé N avec une épaisseur de 1µm à 5µm, la deuxième couche 12 est en un alliage ternaire ou quaternaire de l'Indium intrinsèque avec une épaisseur de 100nm à 400nm, la troisième couche 13 et la quatrième couche 15 sont en InP dopé P avec une épaisseur de 1µm à 2µm, la couche d'arrêt de gravure 14 est en GalnAsP, la couche de contact ohmique 16 est en GaInAs dopé P avec une épaisseur de 100nm à 300nm, la couche sacrificielle 17 est en InP avec une épaisseur supérieure à 1µm, de préférence supérieure à 5µm.

La première étape est réalisable par la croissance de couches minces par épitaxie ou par dépôt par pulvérisation.

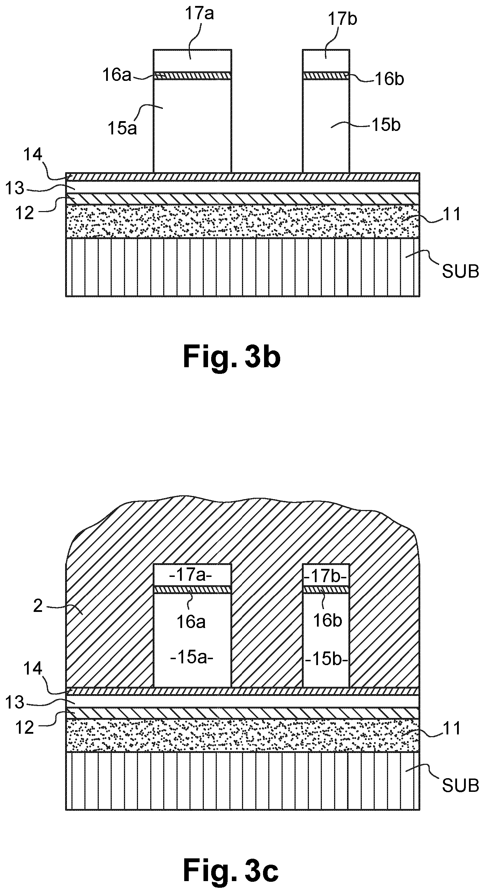

La figure 3b illustre la deuxième étape ii) du procédé de fabrication du composant optoélectronique D1 selon l'invention. La deuxième étape ii) consiste à fabriquer un premier ruban intermédiaire 17a,16a,15a et un second ruban intermédiaire 17b,16b,15b en gravant localement la couche sacrificielle 17, la couche de contact ohmique 16 et la troisième couche 15. Chaque ruban intermédiaire s'étend longitudinalement selon une direction de guidage Y orthogonale à la direction d'empilement Z. Le premier ruban intermédiaire est constitué d'une première partie 15a non gravée de la quatrième couche 15, une première partie 16a non gravée de la couche de contact ohmique 16, et une première partie 17a restante de la couche sacrificielle 17. Le second ruban intermédiaire est constitué d'une seconde partie 15b non gravée de la quatrième couche 15, une seconde partie 16b non gravée de la couche de contact ohmique 16, et une seconde partie 17b restante de la couche sacrificielle 17.

La fabrication des rubans intermédiaires est réalisable par une succession d'opérations de lithographie, et de gravure.

Selon une première alternative, il est possible de réaliser une gravure chimique sélective de l'empilement 15,16,17 couche par couche de la manière suivante : Par exemple, pour graver la couche sacrificielle 17 et la quatrième couche 15 en InP, on utilise une solution comprenant l'acide chlorhydrique HCl ou l'acide bromhydrique HBr diluée dans l'eau pure ou tamponnée par de l'acide phosphorique H3PO4. Pour graver la couche de contact ohmique 16, on utilise une solution comprenant de l'acide sulfurique H₂SO₄, de l'eau oxygénée H₂O₂ et de l'eau pure, ou une solution comprenant de l'acide phosphorique H₃PO₄, de l'eau oxygénée et de l'eau pure. Un masque de lithographie est utilisé pour définir le motif du ruban durant la gravure.

Selon une deuxième alternative, il est possible de réaliser une gravure chimique non-sélective de l'empilement 15,16,17. A titre d'exemple, la gravure chimique non-sélective est réalisée par une solution comprenant de l'acide bromhydrique HBr de l'eau oxygénée H₂O₂ et de l'eau pure.

Selon une troisième alternative, il est possible de réaliser une gravure par plasma non-sélective de l'empilement 15,16,17.

La figure 3c illustre la troisième étape iii) du procédé de fabrication du composant optoélectronique D1 selon l'invention. La troisième étape iii) consiste à déposer une couche d'enrobage 2 en nitrure de manière à encapsuler le premier ruban intermédiaire 17a,16a,15a et le second ruban intermédiaire 17b,16b,15b. Préférentiellement, la couche d'enrobage 2 est en nitrure d'aluminium ou en nitrure de bore. Avantageusement, le dépôt est réalisé par pulvérisation pour rester dans des plages de température compatibles avec des semiconducteurs de type III-V constituant les couches du composant en cours de fabrication.

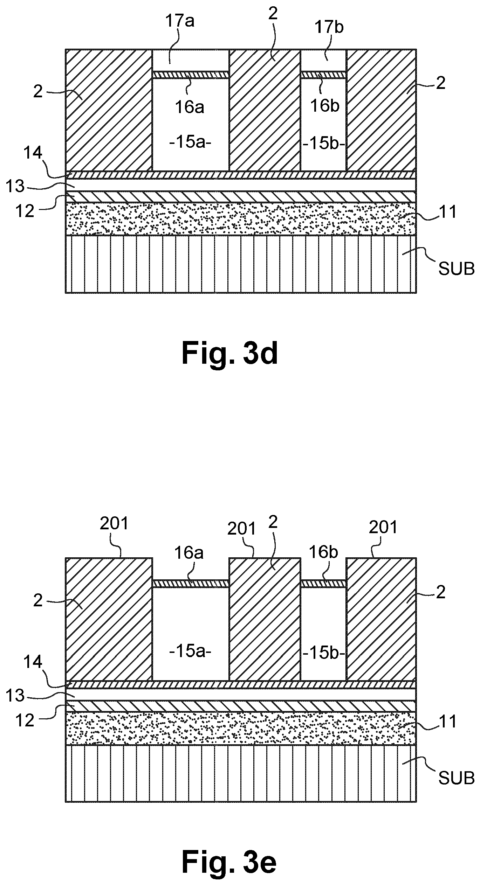

La figure 3d illustre la quatrième étape iv) du procédé de fabrication du composant optoélectronique D1 selon l'invention. La quatrième étape iv) consiste à planariser la couche d'enrobage 2 pour obtenir une surface supérieure plane de la couche d'enrobage 2 et de manière à découvrir la couche sacrificielle 17a, 17b du premier ruban intermédiaire et du second ruban intermédiaire. Le niveau de la couche d'enrobage 2 est abaissé et aplani via un traitement mécanique de polissage ou une combinaison de traitement chimique et mécanique (polissage mécanochimique) pour obtenir une surface supérieure plane, lisse et uniforme. Le polissage doit atteindre au moins la partie supérieure des couches sacrificielles 17a et 17b. Ainsi, on obtient une surface uniforme laissant apparaitre les surfaces supérieures des couches sacrificielles des deux rubans intermédiaires. On obtient ainsi une structuration de la couche d'enrobage 2 sans gravure destructrice des couches semiconductrices de la structure en cours de fabrication. Les couches 11,12,13,14,15a destinées à former l'hétérostructure à crête (élément actif du composant) sont protégées par la couche sacrificielle 17a qui est planarisée (avec la couche d'enrobage 2) par le traitement de l'étape iv). Avantageusement, l'étape de planarisation est réalisée par polissage via une surface abrasive comprenant des billes en diamant ou en aluminium ayant un diamètre inférieur à 5µm. Avantageusement, l'étape de planarisation est suivie d'une étape de polissage utilisant un abrasif comprenant des billes de Al₂O₃ ou de silice colloïdale ayant un diamètre inférieur ou égal à 0,02µm pour araser le dernier micron de la couche 17.

La figure 3e illustre la cinquième étape v) du procédé de fabrication du composant optoélectronique D1 selon l'invention. La cinquième étape v) consiste à graver intégralement les parties restantes de la couche sacrificielle 17a et 17b pour obtenir au moins un ruban de guidage 16a,15a enterré dans la couche d'enrobage 2 en nitrure. La solution de gravure est choisie pour graver uniquement la couche sacrificielle 17a sans endommager la couche de contact ohmique 16a. Pour cela, on utilise une solution de gravure sélective par rapport à la couche de contact ohmique 16 et comprenant l'acide chlorhydrique HCl ou l'acide bromhydrique HBr, par exemple.

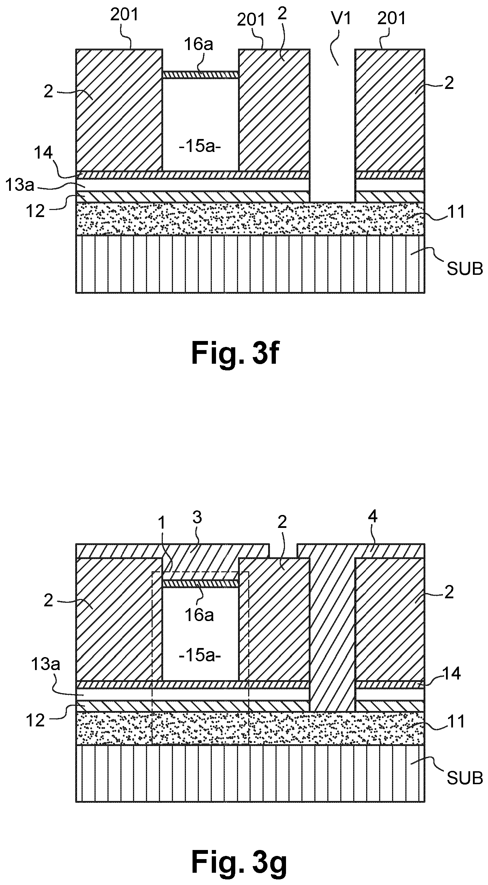

La figure 3f illustre la sixième étape vi) du procédé de fabrication du composant optoélectronique D1 selon l'invention. La sixième étape vi) consiste à fabriquer au moins un via V1 traversant de la surface supérieure 201 de la couche d'enrobage 2 jusqu'à la première couche 11. Selon une première alternative, un seul via V1 est fabriqué et il s'étend parallèlement au ruban de guidage (selon Y). Alternativement, il est possible de réaliser plusieurs vias V1 qui forment une rangée qui s'étend parallèlement au ruban de guidage. Pendant cette étape, les couches 16a et 15a, sont protégées par un masque en diélectrique, ou en résine ou en métal.

Selon une première alternative, il est possible de réaliser une gravure chimique sélective de l'empilement 16b,15b,14,13,12 couche par couche de la manière suivante : Par exemple, pour graver la quatrième couche 15b et la troisième couche 13 en InP on utilise une solution comprenant l'acide chlorhydrique HCl ou l'acide bromhydrique HBr. Pour graver la couche de contact ohmique 16b et la zone active 12 on utilise une solution comprenant l'acide sulfurique H₂SO₄. Pour graver la couche d'arrêt de gravure 14 on utilise une solution comprenant l'acide chlorhydrique ou bromhydrique.

Selon une deuxième alternative, il est possible de réaliser une gravure chimique non-sélective de l'empilement 16b, 15b, 14, 13, 12.

Selon une troisième alternative, il est possible de réaliser une gravure par plasma non-sélective de l'empilement 16b, 15b, 14, 13, 12.

La figure 3g illustre la septième étape vii) du procédé de fabrication du composant optoélectronique D1 selon l'invention. Il s'agit de déposer une première électrode 3 et une seconde électrode 4 en un matériau conducteur. La première électrode 3 présente au moins une première partie déposée sur la couche de contact ohmique 16a. La seconde électrode 4 présente au moins une première partie déposée sur la première couche 11 à travers le via V1 ou la pluralité de via V1 selon la conception choisie dans l'étape précédente. Préalablement à la fabrication de la seconde électrode 4, les parois internes du via V1 sont passivées par le dépôt d'une couche de passivation 41 en diélectrique sur les dites parois internes. La couche de passivation 41 peut être réalisée en silice ou en nitrure de silicium. Avantageusement, la couche de passivation 41 présente une épaisseur de 100nm. Ladite couche de passivation permet d'isoler la seconde électrode 4 d'au moins la zone active 12.

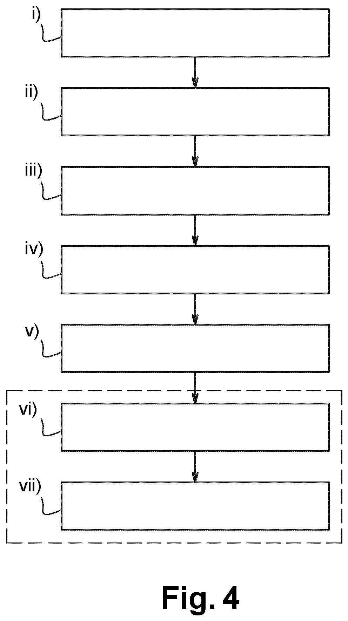

Plus généralement, la figure 4 illustre un organigramme du procédé de fabrication du composant optoélectronique selon l'invention. La première étape i) consiste à fabriquer un empilement de couches semiconductrices déposées sur un substrat SUB selon une direction d'empilement Z. Ledit empilement étant dénommé « empilement initial ».

La deuxième étape ii) consiste à fabriquer un premier ruban intermédiaire 17a,16a,15a et un second ruban intermédiaire 17b,16b,15b en gravant partiellement l'empilement initial. Chaque ruban intermédiaire est couvert (ou chapeauté) par une couche sacrificielle 17a, 17b. Chaque ruban intermédiaire est disposé sur une base formée par les couches non-gravées dudit empilement initial 17a, 17b. Chaque ruban intermédiaire s'étend selon une direction de guidage Y orthogonale à la direction d'empilement Z.

La troisième étape iii) consiste à déposer une couche d'enrobage 2 en nitrure de manière à encapsuler le premier ruban intermédiaire et le second ruban intermédiaire

La quatrième étape iv) consiste à planariser la couche d'enrobage 2 pour obtenir une surface supérieure plane 201 de la couche d'enrobage 2 et de manière à découvrir les couches sacrificielles 17a, 17b du premier ruban intermédiaire 17a,16a,15a et du second ruban intermédiaire 17b,16b,15b. Avantageusement, l'étape de planarisation iv) est réalisée par polissage via une surface abrasive comprenant des billes ayant un diamètre inférieur à 5µm. Avantageusement, l'étape de planarisation- iv) est suivie d'une étape de polissage utilisant un abrasif comprenant des billes ayant un diamètre inférieur ou égal à 0,02µm.

La cinquième étape v) consiste à enlever intégralement les couches sacrificielles 17a, 17b par gravure pour obtenir au moins un ruban de guidage 16a, 15a enterré dans la couche d'enrobage 2 en nitrure à partir du premier ruban intermédiaire 17a,16a,15a.

Optionnellement, la sixième étape vi) consiste à fabriquer au moins un via V1 traversant afin d'atteindre une structure de confinement inférieure de l'empilement en gravant intégralement ou partiellement le second ruban intermédiaire 17b,16b,15b.

Ensuite, la septième étape vii) consiste à déposer une première électrode 3 en un matériau conducteur ayant au moins une première partie déposée sur la surface supérieure du ruban de guidage 13a,14,15a et une seconde électrode 4 en un matériau conducteur remplissant le via V1. Préalablement à la fabrication de la seconde électrode 4, les parois internes du via V1 sont passivées par le dépôt d'une couche de passivation 41 en diélectrique sur les dites parois internes. La couche de passivation 41 peut être réalisée en silice ou en nitrure de silicium. Avantageusement, la couche de passivation 41 présente une épaisseur de 100nm. Ladite couche de passivation permet d'isoler la seconde électrode 4 d'au moins la zone active 12.

Le procédé selon l'invention permet ainsi de fabriquer une hétérostructure à crête enterrée dans une couche d'enrobage en nitrure, plus particulièrement en AIN ou SiN ou BN, sans avoir recours à une opération de gravure de la couche d'enrobage. Cela permet d'éviter le recours à des solutions de gravure agressives pouvant endommager l'hétérostructure à crête. On obtient ainsi, un composant optoélectronique présentant des avantages considérables en termes d'amélioration de la dissipation thermique et de l'isolation électrique par rapport aux solutions de l'état de l'art.

## Revendications

1. Composant optoélectronique (D1) comprenant un empilement de couches sur un substrat (SUB) selon une direction d'empilement (Z) ; ledit empilement comprenant :
- une hétérostructure à crête (1) comprenant une base (13a) et un ruban de guidage (15a) s'étendant selon une direction de guidage (Y) orthogonale à la direction d'empilement (Z) , le ruban de guidage (15a) étant configuré pour propager une onde lumineuse confinée ; l'hétérostructure à crête (1) comprenant :
• une structure de confinement inférieure (11) réalisée en un premier matériau semiconducteur ;
• une zone active (12) réalisée en au moins un deuxième matériau semiconducteur ;
• une structure de confinement supérieure (13a, 14, 15a) réalisée en un troisième matériau semiconducteur ;
la zone active étant confinée entre la structure de confinement supérieure (13a, 14, 15a) et la structure de confinement inférieure (11) ; ladite zone active étant conçue pour générer des photons par recombinaison de porteurs de charges injectés dans les structures de confinement supérieure (13a, 14, 15a) et inférieure (11) ; le ruban de guidage (15a) étant formé par au moins une partie (15a) de la structure de confinement supérieure (13a, 14, 15a) ;
ledit empilement comprenant en outre:
- une couche d'enrobage (2) en nitrure, dans laquelle ledit ruban de guidage (13a, 14, 15a) est enterré ;
- une première électrode (3) formée par une couche en un matériau conducteur ayant au moins une première partie déposée sur la surface supérieure du ruban de guidage (15a) ;
- une seconde électrode (4) formée par une couche en un matériau conducteur connectée à la structure de confinement inférieure (11) à travers un via (V1) traversant la couche d'enrobage (2) ;
chacune des électrodes (3, 4) présente au moins une seconde partie déposée sur la surface supérieure (201) de la couche d'enrobage (2).

2. Composant optoélectronique (D1) selon la revendication 1 dans lequel la couche d'enrobage (2) est en nitrure d'aluminium ou en nitrure de bore.

3. Composant optoélectronique (D1) selon l'une quelconque des revendications 1 ou 2 dans lequel la couche d'enrobage (2) présente une épaisseur supérieure à la hauteur du ruban de guidage (15a).

4. Composant optoélectronique (D1) selon l'une quelconque des revendications 1 à 3 dans lequel la couche d'enrobage (2) présente une surface supérieure plane.

5. Composant optoélectronique (D1) selon l'une quelconque des revendications 1 à 4 dans lequel la structure de confinement supérieure (13a, 14, 15a) est dopée N et la structure de confinement inférieure (11) est dopée P ou inversement.

6. Composant optoélectronique (D1) selon l'une quelconque des revendications 1 à 5 dans lequel l'hétérostructure à crête (1) comprend une couche d'arrêt de gravure (14) pour réaliser une gravure sélective dudit troisième matériau semiconducteur formant le ruban de guidage (15a); ladite couche d'arrêt de gravure (14) étant confinée entre la base (13a) et le ruban de guidage (15a).

7. Composant optoélectronique (D1) selon la revendication 6 dans lequel la couche d'arrêt de gravure (14) présente une épaisseur inférieure 20 nm.

8. Composant optoélectronique (D1) selon l'une quelconque des revendications 1 à 7 comprenant en outre une couche de contact ohmique (16a) déposée sur la surface supérieure du ruban de guidage (15a) ; la couche de contact ohmique (16a) étant réalisée par un quatrième matériau semiconducteur ayant un gap d'énergie inférieur à celui du troisième matériau semiconducteur.

9. Procédé de fabrication d'un dispositif optoélectronique (D1) selon la revendication 1, comprenant les étapes suivantes :
i) fabriquer un empilement de couches semiconductrices déposées sur un substrat (SUB) selon une direction d'empilement (Z) ; ledit empilement étant dénommé « empilement initial » ;
ii) fabriquer un premier ruban intermédiaire (17a,16a,15a) et un second ruban intermédiaire (17b,16b,15b) en gravant partiellement l'empilement initial ; chaque ruban intermédiaire étant couvert par une couche sacrificielle (17a, 17b) ; chaque ruban intermédiaire étant disposé sur une base formée par les couches non-gravées dudit empilement initial (17a, 17b) ; chaque ruban intermédiaire s'étendant selon une direction de guidage (Y) orthogonale à la direction d'empilement (Z) ;
iii) déposer une couche d'enrobage (2) en nitrure de manière à encapsuler le premier ruban intermédiaire (17a,16a,15a) et le second ruban intermédiaire (17b,16b,15b) ;
iv) planariser la couche d'enrobage (2) pour obtenir une surface supérieure plane de la couche d'enrobage (2) et de manière à découvrir la couche sacrificielle (17a, 17b) du premier ruban intermédiaire (17a,16a,15a) et du second ruban intermédiaire (17b,16b,15b) ;
v) enlever intégralement la couche sacrificielle (17a, 17b) par gravure pour obtenir au moins un ruban de guidage (16a,15a) enterré dans la couche d'enrobage (2) en nitrure à partir du premier ruban intermédiaire (17a,16a,15a).

10. Procédé de fabrication d'un dispositif optoélectronique (D1) selon la revendication 9 dans lequel l'empilement initial comprend dans l'ordre en partant dudit substrat :
• une première couche (12) dopé N ou P en un premier matériau semiconducteur destinée à former une structure de confinement inférieure (11) ;
• au moins une deuxième couche (12) en un deuxième matériau semiconducteur ayant un gap d'énergie inférieur à celui du premier matériau semiconducteur destinée à former une zone active (12) ;
• au moins une troisième couche (13, 14, 15) ayant un dopage opposé à celui de la première couche (12), réalisée par un troisième matériau semiconducteur ayant un gap d'énergie supérieur à celui du deuxième matériau semiconducteur et destinée à faire partie d'une structure de confinement supérieure (13) ;
• une couche de contact ohmique (16) en un quatrième matériau semiconducteur ayant un gap d'énergie inférieur à celui du troisième matériau semiconducteur ;
• une couche sacrificielle (17) en un cinquième matériau permettant de réaliser une gravure sélective par rapport à la couche de contact ohmique (16) ;

11. Procédé de fabrication d'un dispositif optoélectronique (D1) selon la revendication 10 dans lequel l'étape ii) est réalisée en gravant partiellement la couche sacrificielle (17), la couche de contact ohmique (16) et l'au moins une troisième couche (15) ;

12. Procédé de fabrication d'un dispositif optoélectronique (D1) selon l'une quelconque des revendications 10 ou 11 comprenant en outre les étapes suivantes :
vi) fabriquer au moins un via (V1) traversant jusqu'à la première couche (11) en gravant intégralement ou partiellement le second ruban intermédiaire (17b, 16b, 15b) et partiellement au moins la deuxième couche (12) ;
vii) déposer une première électrode (3) en un matériau conducteur ayant au moins une première partie déposée sur la surface supérieure du ruban de guidage (13a,14,15a) et une seconde électrode (4) en un matériau conducteur ayant au moins une première partie déposée sur la première couche (11) à travers l'au moins via (V1).

13. Procédé de fabrication d'un dispositif optoélectronique (D1) selon l'une quelconque des revendications 9 à 12 dans lequel l'étape de planarisation iv) est réalisée par polissage via une surface abrasive comprenant des billes ayant un diamètre inférieur à 5µm.

## Patentansprüche

1. Optoelektronisches Bauelement (D1), das einen Stapel von Schichten auf einem Substrat (SUB) in einer Stapelrichtung (Z) umfasst; wobei der Stapel umfasst:
- eine Heterostruktur mit Grat (1), die eine Basis (13a) und ein Führungsband (15a) umfasst, das sich in einer Führungsrichtung (Y) orthogonal zur Stapelrichtung (Z) erstreckt, wobei das Führungsband (15a) konfiguriert ist, um eine begrenzte Lichtwelle zu verbreiten; wobei die Heterostruktur mit Grat (1) umfasst:
- eine untere Begrenzungsstruktur (11), die aus einem ersten Halbleiterwerkstoff realisiert ist;
- eine aktive Zone (12), die aus mindestens einem zweiten Halbleiterwerkstoff realisiert ist;
- eine obere Begrenzungsstruktur (13a, 14, 15a), die aus einem dritten Halbleiterwerkstoff realisiert ist;
wobei die aktive Zone zwischen der oberen Begrenzungsstruktur (13a, 14, 15a) und der unteren Begrenzungsstruktur (11) begrenzt ist; wobei die aktive Zone gestaltet ist, um Photonen durch Rekombination von in die obere (13a, 14, 15a) und untere Begrenzungsstruktur (11) injizierten Ladungsträgern zu erzeugen; wobei das Führungsband (15a) durch mindestens einen Teil (15a) der oberen Begrenzungsstruktur (13a, 14, 15a) gebildet wird;
wobei der Stapel weiter umfasst:
- eine Überzugschicht (2) aus Nitrid, in der das Führungsband (13a, 14, 15a) vergraben ist;
- eine erste Elektrode (3), die durch eine Schicht aus einem leitenden Werkstoff gebildet ist, der mindestens einen ersten Teil aufweist, der auf der oberen Oberfläche des Führungsbandes (15a) abgeschieden ist;
- eine zweite Elektrode (4), die durch eine Schicht aus einem leitenden Werkstoff gebildet ist, der mit der unteren Begrenzungsstruktur (11) durch eine Durchkontaktierung (V1) hindurch verbunden ist, welche die Überzugschicht (2) durchquert;
wobei jede der Elektroden (3, 4) mindestens einen zweiten Teil aufweist, der auf der oberen Oberfläche (201) der Überzugschicht (2) abgeschieden ist.

2. Optoelektronisches Bauelement (D1) nach Anspruch 1 wobei die Überzugschicht (2) aus Aluminiumnitrid oder aus Bornitrid ist.

3. Optoelektronisches Bauelement (D1) nach einem der Ansprüche 1 oder 2 wobei die Überzugschicht (2) eine Dicke größer als die Höhe des Führungsbandes (15a) aufweist.

4. Optoelektronisches Bauelement (D1) nach einem der Ansprüche 1 bis 3 wobei die Überzugschicht (2) eine ebene obere Oberfläche aufweist.

5. Optoelektronisches Bauelement (D1) nach einem der Ansprüche 1 bis 4, wobei die obere Begrenzungsstruktur (13a, 14, 15a) N-dotiert ist und die untere Begrenzungsstruktur (11) P-dotiert ist oder umgekehrt.

6. Optoelektronisches Bauelement (D1) nach einem der Ansprüche 1 bis 5, wobei die Heterostruktur mit Grat (1) eine Gravur-Sperrschicht (14) umfasst, um eine selektive Gravur des dritten Halbleiterwerkstoffs, der das Führungsband (15a) bildet zu realisieren; wobei die Gravur-Sperrschicht (14) zwischen der Basis (13a) und dem Führungsband (15a) begrenzt ist.

7. Optoelektronisches Bauelement (D1) nach Anspruch 6, wobei die Gravur-Sperrschicht (14) eine Dicke von weniger als 20 nm aufweist.

8. Optoelektronisches Bauelement (D1) nach einem der Ansprüche 1 bis 7, das weiter eine ohmsche Kontaktschicht (16a) umfasst, die auf der oberen Oberfläche des Führungsbandes (15a) abgeschieden ist; wobei die ohmsche Kontaktschicht (16a) aus einem vierten Halbleiterwerkstoff realisiert ist, der eine Energielücke aufweist, die geringer als jene des dritten Halbleiterwerkstoffes ist.

9. Verfahren zum Herstellen eines optoelektronischen Bauelements (D1) nach Anspruch 1, die folgenden Schritte umfassend:
i) Herstellen eines Stapels aus Halbleiterschichten, die auf einem Substrat (SUB) in einer Stapelrichtung (Z) abgeschieden sind; wobei der Stapel als "Anfangsstapel" bezeichnet wird;
ii) Herstellen eines ersten Zwischenbandes (17a,16a,15a) und eines zweiten Zwischenbandes (17b,16b,15b) durch teilweise Gravieren des Anfangsstapels; wobei jedes Zwischenband von einer Opferschicht (17a, 17b) bedeckt ist; wobei jedes Zwischenband auf einer Basis angeordnet ist, die durch die nicht gravierten Schichten des Anfangsstapels (17a, 17b) gebildet wird; wobei sich jedes Zwischenband in einer Führungsrichtung (Y) orthogonal zur Stapelrichtung (Z) erstreckt;
iii) Abscheiden einer Überzugschicht (2) aus Nitrid, um das erste Zwischenband (17a,16a,15a) und das zweite Zwischenband (17b,16b,15b) einzukapseln;
iv) Planieren der Überzugschicht (2), um eine ebene obere Oberfläche der Überzugschicht (2) zu erhalten, und um die Opferschicht (17a, 17b) des ersten Zwischenbandes (17a,16a,15a) und des zweiten Zwischenbandes (17b,16b,15b) freizulegen;
v) vollständig Entfernen der Opferschicht (17a, 17b) durch Gravieren, um mindestens ein Führungsband (16a,15a), das in der Überzugschicht (2) aus Nitrid vergraben ist, aus dem ersten Zwischenband (17a,16a,15a) zu erhalten.

10. Verfahren zum Herstellen eines optoelektronischen Bauelements (D1) nach Anspruch 9, wobei der Anfangsstapel in der Reihenfolge ab dem Substrat umfasst:
- eine erste N- oder P-dotierte Schicht (12) aus einem ersten Halbleiterwerkstoff, die dazu bestimmt ist, eine untere Begrenzungsstruktur (11) zu bilden;
- mindestens eine zweite Schicht (12) aus einem zweiten Halbleiterwerkstoff, der eine Energielücke aufweist, die geringer als jene des ersten Halteleiterwerkstoffes ist, der dazu bestimmt ist, eine aktive Zone (12) zu bilden;
- mindestens eine dritte Schicht (13, 14, 15), die eine gegensätzliche Dotierung zu jener der ersten Schicht (12) aufweist, die aus einem dritten Halbleiterwerkstoff realisiert ist, der eine Energielücke aufweist, die größer als jene des zweiten Halbleiterwerkstoffes ist und dazu bestimmt ist, Teil einer oberen Begrenzungsstruktur (13) zu sein;
- eine ohmsche Kontaktschicht (16) aus einem vierten Halbleiterwerkstoff, der eine Energielücke aufweist, die geringer als jene des dritten Halbleiterwerkstoffes ist;
- eine Opferschicht (17) aus einem fünften Werkstoff, die es ermöglicht, eine selektive Gravur in Bezug auf die ohmsche Kontaktschicht (16) zu realisieren;

11. Verfahren zur Herstellung eines optoelektronischen Bauelements (D1) nach Anspruch 10, wobei der Schritt ii) durch teilweise Gravieren der Opferschicht (17), der ohmschen Kontaktschicht (16) und der mindestens einen dritten Schicht (15) realisiert wird;

12. Verfahren zum Herstellen eines optoelektronischen Bauelements (D1) nach einem der Ansprüche 10 oder 11, weiter die folgenden Schritte umfassend:
vi) Herstellen mindestens einer Durchkontaktierung (V1), die bis zur ersten Schicht (11) durchquert, durch vollständig oder teilweise Gravieren des zweiten Zwischenbandes (17b,16b,15b) und teilweise mindestens der zweiten Schicht (12);
vii) Abscheiden einer ersten Elektrode (3) aus einem leitenden Werkstoff, die mindestens einen ersten Teil aufweist, der auf der oberen Oberfläche des Führungsbandes (13a,14,15a) abgeschieden ist, und einer zweiten Elektrode (4) aus einem leitenden Werkstoff, die mindestens einen ersten Teil aufweist, der auf der ersten Schicht (11) durch die mindestens eine Durchkontaktierung (V1) hindurch abgeschieden ist.

13. Verfahren zur Herstellung eines optoelektronischen Bauelements (D1) nach einem der Ansprüche 9 bis 12, wobei der Planierungsschritt iv) durch Polieren über eine raue Oberfläche realisiert wird, die Kügelchen umfasst, die einen Durchmesser von weniger als 5µm aufweisen.

## Claims

1. Optoelectronic component (D1) comprising a stack of layers on a substrate (SUB) in a stacking direction (Z); the stack comprising:
- a ridged heterostructure (1) comprising a base (13a) and a guiding band (15a) extending in a guiding direction (Y) orthogonal to the stacking direction (Z), the guiding band (15a) being configured to propagate a confined light wave; the ridged heterostructure (1) comprising:
• a lower confinement structure (11) made from a first semiconductor material;
• an active zone (12) made from at least a second semiconductor material;
• an upper confinement structure (13a, 14, 15a) made from a third semiconductor material;
the active zone being confined between the upper confinement structure (13a, 14, 15a) and the lower confinement structure (11); the active zone being configured to generate photons by means of recombination of charge carriers which are injected into the upper confinement structure (13a, 14, 15a) and lower confinement structure (11); the guiding band (15a) being formed by at least one portion (15a) of the upper confinement structure (13a, 14, 15a);
the stack further comprising:
- a coating layer (2) made of nitride, in which the guiding band (13a, 14, 15a) is embedded;
- a first electrode (3) formed by means of a layer of a conductive material which has at least a first portion which is deposited on the upper surface of the guiding band (15a);
- a second electrode (4) which is formed by a layer of a conductive material which is connected to the lower confinement structure (11) through an opening (V1) which extends through the coating layer (2);
each of the electrodes (3, 4) has at least a second portion which is deposited on the upper surface (201) of the coating layer (2).

2. Optoelectronic component (D1) according to claim 1, wherein the coating layer (2) is made of aluminium nitride or boron nitride.

3. Optoelectronic component (D1) according to either claim 1 or claim 2, wherein the covering layer (2) has a thickness greater than the height of the guiding band (15a).

4. Optoelectronic component (D1) according to any one of claims 1 to 3, wherein the coating layer (2) has a planar upper surface.

5. Optoelectronic component (D1) according to any one of claims 1 to 4, wherein the upper confinement structure (13a, 14, 15a) is N-doped and the lower confinement structure (11) is P-doped, or vice versa.

6. Optoelectronic component (D1) according to any one of claims 1 to 5, wherein the ridged heterostructure (1) comprises an etching stop layer (14) in order to carry out a selective etching of the third semiconductor material which forms the guiding band (15a); the etching stop layer (14) being confined between the base (13a) and the guiding band (15a).

7. Optoelectronic component (D1) according to claim 6, wherein the etching stop layer (14) has a thickness less than 20 nm.

8. Optoelectronic component (D1) according to any one of claims 1 to 7, further comprising an ohmic contact layer (16a) deposited on the upper surface of the guiding band (15a); the ohmic contact layer (16a) being produced by means of a fourth semiconductor material which has an energy gap less than that of the third semiconductor material.

9. Method for producing an optoelectronic device (D1) according to claim 1, comprising the following steps of:
i) producing a stack of semiconductor layers which are deposited on a substrate (SUB) in a stacking direction (Z); the stack being referred to as an "initial stack";
ii) producing a first intermediate band (17a,16a,15a) and a second intermediate band (17b,16b,15b) by partially etching the initial stack; each intermediate band being covered by a sacrificial layer (17a, 17b); each intermediate band being arranged on a base formed by the non-etched layers of the initial stack (17a, 17b); each intermediate band extending in a guiding direction (Y) orthogonal to the stack direction (Z);
iii) depositing a coating layer (2) made of nitrate in order to encapsulate the first intermediate band (17a,16a,15a) and the second intermediate band (17b,16b,15b);
iv) planarizing the coating layer (2) in order to obtain a planar upper surface of the coating layer (2) and in order to uncover the sacrificial layer (17a, 17b) of the first intermediate band (17a,16a,15a) and the second intermediate band (17b,16b,15b);
v) completely removing the sacrificial layer (17a, 17b) by means of etching in order to obtain at least one guiding band (16a,15a) which is embedded in the coating layer (2) made of nitride from the first intermediate band (17a,16a,15a).

10. Method for producing an optoelectronic device (D1) according to claim 9, in which the initial stack comprises in order starting from the substrate:
• a first layer (12) which is N-doped or P-doped with a first semiconductor material which is intended to form a lower confinement structure (11);
• at least a second layer (12) made of a second semiconductor material which has an energy gap which is less than that of the first semiconductor material which is intended to form an active zone (12);
• at least a third layer (13, 14, 15) which has a doping opposed to that of the first layer (12) and which is produced by means of a third semiconductor material which has an energy gap greater than that of the second semiconductor material and which is intended to be part of an upper confinement structure (13);
• an ohmic contact layer (16) made of a fourth semiconductor material which has an energy gap less than that of the third semiconductor material;
• a sacrificial layer (17) made of a fifth material which enables a selective etching to be carried out relative to the ohmic contact layer (16).

11. Method for producing an optoelectronic device (D1) according to claim 10, in which the step ii) is carried out by partially etching the sacrificial layer (17), the ohmic contact layer (16) and the at least one third layer (15).

12. Method for producing an optoelectronic device (D1) according to either claim 10 or claim 11, further comprising the following steps of:
vi) producing at least one opening (V1) which extends as far as the first layer (11) by completely or partially etching the second intermediate band (17b,16b,15b) and partially at least the second layer (12);
vii) depositing a first electrode (3) made of a conductive material which has at least a first portion which is deposited on the upper surface of the guiding band (13a,14,15a) and a second electrode (4) made of a conductive material which has at least a first portion which is deposited on the first layer (11) through the at least one opening (V1).

13. Method for producing an optoelectronic device (D1) according to any one of claims 9 to 12, in which the planarization step iv) is carried out by means of polishing via an abrasive surface which comprises balls which have a diameter less than 5 µm.
